# EUROPEAN PATENT SPECIFICATION

(11) **EP 0 458 948 B1**
(45) Date of publication and mention of the grant of the patent: **31.08.1994**
(21) Application number: 91901704.6
(22) Date of filing: 08.11.1990
(51) Int. Cl.: C23G 1/14, C11D 7/18

(54) **PEROXIDE COMPOSITION FOR REMOVING FLUX RESIDUE AND METHOD OF USING SAME**
PEROXIDZUSAMMENSETZUNG ZUM ENTFERNEN VON ZUNDER UND VERFAHREN ZU DEREN VERWENDUNG
COMPOSITION DE PEROXYDE POUR L'ELIMINATION DE LA CALAMINE ET SA METHODE D'UTILISATION

(30) Priority: 20.12.1989 US 453446
(43) Date of publication of application: 04.12.1991
(73) Proprietor: Hughes Aircraft Company, Los Angeles, California 90045-0066 (US)
(72) Inventor: JACKSON, David P., Saugus, CA 91350 (US)
(74) Representative: Grünecker, Kinkeldey, Stockmair & Schwanhäusser Anwaltssozietät
(86) International application number: US9006464
(87) International publication number: WO9109987

(56) References cited:
- EP-A- 0 009 839
- EP-A- 0 174 610
- WO-A-88/09368
- DE-A- 3 215 966
- DATABASE WORLD PATENT INDEX, File Server, Accession no. 85-234441, week 38, 1985, Derwent Publication Ltd., London, GB; & JP-A-60 153 982
- PATENT ABSTRACTS OF JAPAN, vol. 12, no. 223 (C507)(3070), June 24, 1988; & JP-A- 63 20 489

## Description

The present invention relates to a composition and method for removing flux residue from a chosen solid substrate. More particularly, the present invention relates to a hydrogen peroxide composition for removing flux residue; and to a method of using this composition.

In the fabrication of printed circuit boards, integrated circuits, and various electronic components and devices, solder is used to join various component metal parts together. The solder itself comprises an alloy, such as of zinc and copper or of tin and lead. Prior to application of the solder to the metal surface, the surface is treated with a fluxing agent to remove oxides and other contaminants which might interfere with the metal bonding, and to prevent reformation thereof during the solder process. These fluxing agents are typically organic materials such as natural rosin extracted from pine tree sap, organic acids such as carboxylic acid, hydrazines, amines and amides, or inorganic materials such as inorganic acids or salts. The most commonly used fluxing agent is acid rosin flux. The term "rosin flux" is used herein to mean a flux material which comprises rosin, i.e., the resin after distilling turpentine from the exudation of species of pine, and containing abietic acid and its anhydride. Typically, a small amount of another acid is added to rosin flux to activate it and such compositions are referred to as "acid rosin flux" or "activated rosin flux." After the solder operation has been completed, excess flux as well as flux residues remain on the soldered surface, and these residues are resinous, waxy and conductive. These flux residues and excess flux must be removed prior to subsequent processing steps in order to prevent reaction thereof with the bonded part, leading to corrosion and resultant electrical insulation losses.

Defluxing solvents which are widely used at present are halogenated hydrocarbons such as 1,1,1-trichloroethane and Freon (a tradename of E. I. DuPont for polyhalogenated hydrocarbons including chlorine and fluorine). While these organic materials are effective defluxing solvents, they have the serious disadvantage that they have a negative impact on the environment due to air pollution and ozone depletion. In fact, recent environmental legislation mandates that these materials be banned or their production severely restricted in the next few years. When these materials are used, even in small quantities, expensive management systems for transport, storage, use, and disposal and environmental protection equipment must be used to prevent air and water discharges. In addition, waste solvents require energy intensive regeneration operations for these materials.

While numerous aqueous cleaners are available which are viable degreasing solvents, none of these has been found to be effective as an electronic component defluxing solvent. In addition, the resulting organic-laden aqueous solvents require further processing before disposal.

Thus, an urgent need exists in the electronics industry for a solvent which effectively removes flux residues while at the same time avoiding any negative environmental impact.

EP-A-0174610 discloses a low foaming peroxide composition suitable for the treatment of solid surfaces, e.g. of textiles or metals.

The object of the present invention is to provide a composition and method for removing flux residue from a chosen solid substrate while simultaneously avoiding negative environmental impact.

The object of the present invention is accomplished by providing a composition comprising:
(a) hydrogen peroxide in the amount of about 3 to 5 percent by weight of said composition;
(b) a metal hydroxide in sufficient amount to provide a pH of at least 10.5 in said composition;
(c) a wetting agent in the amount of about 0.1 to 0.3 percent by weight of said composition, said wetting agent being selected from sodium 2-ethylhexyl sulfate or sodium sodium metasilicate; and
(d) purified water as the balance of said composition,
with the proviso that said composition does not include magnesium sulfate and HEDP.

Furthermore, the present invention provides a method for removing flux residue from a chosen solid substrate by exposing said solid substrate having said flux residue to said composition whereby said flux residue is removed from said substrate and converted into non-toxic and non-hazardous products.

Thus, negative environmental impact is avoided by the present process.

Optionally, if the substrate comprises metal, the composition may further comprise a metal protective agent in the amount of about 0.5 to 2.0 percent by weight of said composition to protect the metal surface from attack by the peroxide and alkali.

In an alternative embodiment of the present invention, the flux residue removal is further enhanced by exposing the composition and the flux residues on the substrate to ultraviolet radiation.

The composition of the present invention is effective for removing flux residues which contaminate surfaces after a soldering operation while at the same time avoiding undesirable impact on the environment. These flux residues typically comprise resinous, waxy contaminants which are the breakdown products from the soldering operation. The substrates which are soldered comprise, for example, printed wiring boards, integrated circuits, electronic components, electronic devices, electronic connectors, or electronic cables. In accordance with the present invention, the by-products, such as carbon dioxide, nitrogen, and water, which are formed are non-hazardous and can be removed without having a negative environmental impact.

The hydrogen peroxide acts as a solvent, emulsifier, and oxidant. While not limiting the present invention to a particular theory of operation, it is believed that the hydrogen peroxide has the following effect. After being immersed in the present composition, a flux-contaminated substrate invokes selective adsorption of hydrogen peroxide into the flux film and rapid decomposition of the hydrogen peroxide. The selective adsorption of hydrogen peroxide by the rosin-based contaminant films is due to the ether-like solubility chemistry of hydrogen peroxide. Following adsorption, hydrogen peroxide rapidly decomposes into water and oxygen gas. The oxygen emulsifies the resinous contaminants, increasing surface area and solvency. This adsorption and emulsification process is observed as spontaneous foaming on the contaminated surface. The scrubbing foam enhances the cleaning activity of the solvent, dramatically improving penetration of solvent into low-tolerance spacings. After the organic flux contaminants have been removed from the substrate, they are oxidized by the action of nascent or atomic oxygen which is formed by the spontaneous decomposition or hydrogen peroxide, and are decomposed into carbon dioxide, nitrogen, and water. This effect is evidenced by a change in color in the composition from amber when it contains dissolved flux, to clear. The contaminants may be dissolved or suspended material.

The effectiveness of the composition of the present invention is believed to be due to a synergistic relationship between pH, peroxide chemistry and the wetting agent. It was found that peroxide-based formulations with pH's of 2 (acidic) and 7 (neutral) did not effectively remove contaminants. In these cases, the flux contaminants tended to gel and discolor on the substrate surfaces. Alkaline formulations having a pH of greater than 10.5 were considerably more effective at solubilizing the flux residues than acid or neutral solutions. (This is probably due to ionization of flux acids by basic solutions, forming primative soaps.) Thus, the alkaline compound is added to the present composition to provide a pH of at least 10.5, preferably within the range of 10.5 to 11.5. The alkaline compound may be, for example, sodium hydroxide or potassium hydroxide, with sodium hydroxide being most preferred. If sodium hydroxide is used, it is present in the amount of about 0.2 to 0.5 percent by weight of the composition.

The wetting agent must be chosen to be compatible with the other components in the present composition. Conventional wetting agents such as sodium alkylaryl sulfonate and other organic synthetic detergents decompose rapidly in the presence of strong alkaline oxidizing/bleaching solutions such as the composition of the present invention. This results in rapid decomposition of the hydrogen peroxide solvent and excessive foaming in the solution. A suitable wetting agent for use in the present composition is sodium 2-ethylhexyl sulfate. It has good solubility, stability, and penetrating action in near-boiling alkaline and acid solutions, and is one of the few anionic surfactants stable in concentrated bleaching solutions. Another suitable wetting agent for practising the present invention is sodium metasilicate. The wetting agent is used in the present invention in the amount of about 0.1 to 0.3 percent by weight of the composition.

If the substrate comprises a metal, such as in a printed wiring board, the metal surfaces must be protected from attack by the peroxide and alkali in the present composition. The particular metal protective agent used depends on the specific metal being protected. For example, calcium and phosphorous compounds are used as protective agents for copper. The selection of the particular protective agent for a particular metal is known in the art and will not be detailed here. Suitable metal protective agents for practising the present invention include sodium carbonate or sodium metasilicate.

The optimum operating temperature of the present composition to provide effective residue removal within a short period of time is within the range of 51.7 to 71.1°C (125 to 160°F). Within this range, flux residues may be removed in 1 to 3 minutes. A preferred temperature for use of the present composition is about 60°C (140°F). The increased temperature promotes the reaction, improves penetration of the composition, and keeps particulates in suspension so that they do not deposit on the cleaned substrates. In addition, the elevated temperature optimizes the effectiveness of the ultraviolet radiation for cleaving bonds in the residue, as described below.

The flux residues which can be removed in accordance with the present invention comprise oils, resins, and other organic materials.

The solid substrate from which residues can be removed in accordance with the present invention may comprise any material which is not adversely affected by the peroxide or alkaline components of the present composition. Such materials include, but are not limited to, polyimide/ polyamide laminates and epoxy/glass laminates which are used in printed wiring boards, silicon which is used in electronic devices, and anodized aluminum or polyimide which are used in cables and connectors. The solid substrate may have a simple or complex configuration and may include interstitial spaces which are difficult to clean by known methods. The substrate may be in the form of a continuous layer or in the form of discrete particles.

In accordance with an alternative embodiment of the present invention, ultraviolet radiation is used to enhance the cleaning process. When hydrogen peroxide is exposed to ultraviolet radiation having a wavelength within the range of 184 to 300 nanometers (nm), preferably about 253 nm, such as from a xenon flash lamp, the hydrogen peroxide is dissociated to form a hydroxyl radical (OH⁻) which is very reactive. This hydroxyl radical then cleaves the carbon-to-carbon bonds in the residue forming carbon dioxide and water. In addition, the ultraviolet radiation itself also cleaves the carbon-to-carbon bonds in the residues adding even further effectiveness to the cleaning process. The source of ultraviolet radiation, such as a xenon flash lamp or a mercury vapor lamp, is located external to the chamber containing the substrate to be cleaned and the present composition, and the radiation is directed into the cleaning chamber. For this purpose, a quartz window is provided on one surface of the cleaning chamber to permit transmission of the ultraviolet radiation. Optionally, a focusing barrel may be provided between the quartz window and the radiation source to improve the efficiency of the ultraviolet radiation transmission. Such methods for introducing radiation into reaction chambers are well known.

The composition of the present invention may be used in essentially the same manner as known defluxing agents are used, namely in a spray or soak operation. If used in a soak operation, it is desirable to keep the present composition agitated, by air or mechanical or ultrasonic means. As an added feature in the present method, after the substrate has been treated with the present composition, residual alkaline materials (alkali or alkali salts) remaining on the substrate are neutralized. A preferred neutralization agent comprises hot carbonated water, which is applied at 51.7 to 71.1°C (125 to 160°F). The carbonated water may be formed by bubbling carbon dioxide into deionized water. The use of the carbonated water rinse keeps the rinse water below a pH of 9.5, which is the regulated limit for disposal in a sewer. After the neutralization step, the substrate is rinsed in hot water at 51.7 to 71.1°C (125 to 160°F), preferably with air agitation, and then dried, preferably with hot air. In an exemplary batch processing technique, in which contaminated substrates are loaded into a chamber and treated, in turn, with the present composition, neutralizing agent, water, and hot air, the following approximate processing times may typically be used:

| Step | Time |
|---|---|
| a. Exposure of contaminated substrate to present composition | 3 minutes |
| b. Neutralization | 3 minutes |
| c. Hot water rinse | 4 minutes |
| d. Hot air drying | 5 minutes |

Thus, the present process can be completed within 15 minutes.

Alternatively, the present process may be practised as an "in-line" process. The contaminated substrates are loaded into a rack and the rack is lowered in sequence into a series of chambers containing, respectively, the present composition, the neutralizing agent, and deionized water sprayers. As yet another alternative, this in-line processing may be accomplished by a conveyorized system.

After the substrate has been treated with the present composition, the substrate is removed from the chamber containing the composition. The starting composition is then re-established by the addition of hydrogen peroxide and, if necessary, the other components of the composition. Thus, the bulk cleaning solvent remains in place and does not require disposal. Rather, the composition is regenerated in situ by the addition of component materials as required.

As an added feature of the present invention, the present composition removes metallic oxides from the substrate and thus serves also as a solder brightener. This eliminates the need for a secondary process, such as treatment with fluoroboric acid.

Examples of practise of the present invention are as follows.

### EXAMPLE 1

This example illustrates the use of the composition and method of the present invention to remove solder flux from printed wiring boards.

It should be noted that while the present composition is non-toxic, general safety precautions, such as the use of goggles and protective clothing, are necessary.

The test samples comprised polyimide/polyamide laminate printed wiring boards containing copper metallization and having been exposed to Alpha 611, a solder flux obtained from Alpha Metals Company of Alpharetta, Georgia, and comprising a mildly activated rosin flux. The composition of the present invention comprised; approximately 3.0 percent by weight hydrogen peroxide; approximately 0.2 percent by weight sodium hydroxide; approximately 0.1 percent by weight sodium 2-ethylhexyl sulfate as the wetting agent; approximately 0.5 percent by weight sodium metasilicate as the metal protective agent; and the balance being purified water. The temperature of the composition was maintained at 60°C (140°F). The samples were treated in a batch process as previously described herein using the previously described processing steps and times. The present composition was nearly transparent prior to introduction of flux-contaminated materials, with only trace amounts of gas liberation visible. When the contaminated material was introduced, vigorous gas formation on the flux residue was observed. This action continued as the flux was emulsified and dissolved into solution. Continued gas formation was visible as the dissolved flux residues continued to be oxidized. Completion of the decomposition was indicated by slow gas evolution and change in fluid color. Surface foaming was minimal. Complete removal of the flux residues was accomplished in an average of less than two minutes. The soldered joints were clean and free of oxides, i.e., bright in appearance.

By contrast, it was found that alkaline solutions alone did not effectively separate the bulk of the flux residues from the substrate. In addition, alkaline solutions with wetting agents, but without hydrogen peroxide, required in excess of 10 minutes to separate flux residues from the substrate. Even after separation, the flux residues did not disperse well.

### EXAMPLE 2

This example illustrates the use of the composition and method of the present invention to remove solder flux from cable connectors.

A soft anodized aluminum connector was treated with the composition of the present invention as described in Example 1 except using a temperature of 160°F (71°C) and 60-second rinse times for both the neutralization and final rinse steps. There was no visually detectable degradation of the anodized aluminum by exposure to the present composition.

In another experiment, a cable made of Kapton (a trademark of E.I. du Pont de Nemours for a polyimide) was contaminated with Kester 197, a mildly activated rosin based flux obtained from Litton-Kester Company of Chicago, Illinois. The Kapton cable was treated in accordance with the present invention as described above. Complete removal of the flux was accomplished as determined by visual inspection under 25X magnification.

### EXAMPLE 3

This example illustrates the use of the embodiment of the method of the present invention in which ultraviolet radiation is used to enhance the contaminant removal.

The composition and method described in Example 1 are used except that the composition and the substrate containing contaminants are exposed to radiation from a xenon flash lamp as previously described herein. The cleaning process proceeds generally as described in Example 1, except that complete flux removal is accomplished more rapidly.

As previously discussed, the organic contaminants are oxidized by the present composition to form carbon dioxide, nitrogen, and water. The carbon dioxide and nitrogen are non-hazardous and may be exhausted into the atmosphere. The water by-product contains no noxious material and may be disposed of in a sewer without further treatment or may be re-used. The hydrogen peroxide in the present composition is decomposed during the cleaning operation into atomic oxygen or hydroxyl radicals and water and the former react with the contaminants to form the above-noted products. Insoluble precipitates, such as cellulose gums, may also be formed as by-products of the bond cleaving of the present composition, and may be readily removed by filtration. Thus, no toxic or hazardous materials are formed as a result of the present method. Consequently, the present process obviates the need for the expensive solvent emission control and waste management procedures required when using prior art halogenated solvents. In addition, environmental pollution and exposure of workers to hazardous materials are also avoided by the present composition and method.

## Claims

1. A composition for removing flux residue from a chosen solid substrate by decomposing said flux residue into non-hazardous by-products, said composition comprising:
(a) hydrogen peroxide in the amount of about 3 to 5 percent by weight of said composition;
(b) a metal hydroxide in sufficient amount to provide a pH of at least 10.5 in said composition;
(c) a wetting agent in the amount of about 0.1 to 0.3 percent by weight of said composition, said wetting agent being selected from sodium 2-ethylhexyl sulfate or sodium sodium metasilicate; and
(d) purified water as the balance of said composition,
with the proviso that said composition does not include magnesium sulfate and HEDP. (Hydroxyethanediphosphonic acid)

2. The composition of claim 1 wherein said metal hydroxide is sodium hydroxide or potassium hydroxide.

3. The composition of claim 1 further comprising a metal protective agent in the amount of about 0.5 to 2.0 percent by weight of said composition.

4. The composition of claim 3 wherein:
(a) said hydrogen peroxide is present in the amount of about 3.0 percent by weight of said composition;
(b) said metal hydroxide comprises sodium hydroxide and is present in the amount of about 0.2 percent by weight of said composition;
(c) said wetting agent comprises sodium 2-ethylhexyl sulfate and is present in the amount of about 0.1 percent by weight of said composition.
(d) said metal protective agent comprises sodium metasilicate and is present in the amount of about 0.5 percent by weight of said composition.

5. A method for removing flux residue from a chosen solid substrate while simultaneously avoiding negative environmental impact, said method comprising:
(a) providing a composition comprising:
(1) hydrogen peroxide in the amount of about 3 to 5 percent by weight of said composition;
(2) a metal hydroxide in sufficient amount to provide a pH of at least 10.5 in said composition;
(3) a wetting agent in the amount of about 0.1 to 0.3 percent by weight of said composition, said wetting agent being selected from sodium 2-ethylhexyl sulfate or sodium metasilicate; and
(4) purified water as the balance of said composition,
with the proviso that said composition does not include magnesium sulfate and HEDP; and
(b) exposing said solid substrate having said flux residue to said composition whereby said flux residue is removed from said substrate and converted into non-toxic and non-hazardous products.

6. The method of claim 5 wherein said exposing is performed with said composition at a temperature within the range of 51.7 to 71.1°C (125 to 160°F).

7. The method of claim 5 further comprising after said exposing said substrate to said composition, neutralizing residual said metal hydroxide or products thereof on said substrate, rinsing said substrate with water, and drying said substrate.

8. The method of claim 7 wherein said neutralizing comprises exposing said substrate to hot carbonated water.

9. The method of claim 5 wherein said exposing in step "b" further comprises exposing said composition and said organic contaminants on said substrate to ultraviolet radiation having a wavelength within the range of 184 to 300 nanometers.

## Patentansprüche

1. Zusammensetzung zum Entfernen eines Flußmittelrückstands von einem ausgewählten festen Substrat durch Zersetzung des Flußmittelrückstands in ungefährliche Nebenprodukte, wobei die Zusammensetzung umfaßt:
(a) Wasserstoffperoxid in einer Menge von etwa 3 bis 5 Gew.-%, bezogen auf die Zusammensetzung;
(b) ein Metallhydroxid in einer ausreichenden Menge, um einen pH-Wert von mindestens 10,5 in der Zusammensetzung einzustellen;
(c) ein Netzmittel in einer Menge von etwa 0,1 bis 0,3 Gew.-%, bezogen auf die Zusammensetzung, wobei das Netzmittel aus Natrium-2-ethylhexylsulfat oder Natriummetasilikat ausgewählt ist; und
(d) reines Wasser als Rest der Zusammensetzung,
mit der Maßgabe, daß die Zusammensetzung kein Magnesiumsulfat und HEDP (Hydroxyethandiphosphonsäure) enthält.

2. Zusammensetzung nach Anspruch 1, worin das Metallhydroxid Natriumhydroxid oder Kaliumhydroxid ist.

3. Zusammensetzung nach Anspruch 1, welche weiterhin ein Metallschutzmittel in einer Menge von etwa 0,5 bis 2,0 Gew.-%, bezogen auf die Zusammensetzung, umfaßt.

4. Zusammensetzung nach Anspruch 3, worin:
(a) Wasserstoffperoxid in einer Menge von etwa 3,0 Gew.-%, bezogen auf die Zusammensetzung, vorliegt;
(b) das Metallhydroxid Natriumhydroxid umfaßt, und in einer Menge von etwa 0,2 Gew.-%, bezogen auf die Zusammensetzung, vorliegt;
(c) das Netzmittel Natrium-2-ethylhexylsulfat umfaßt, und in einer Menge von etwa 0,1 Gew.-%, bezogen auf die Zusammensetzung, vorliegt;
(d) das Metallschutzmittel Natriummetasilikat umfaßt, und in einer Menge von etwa 0,5 Gew.-%, bezogen auf die Zusammensetzung, vorliegt.

5. Verfahren zum Entfernen eines Flußmittelrückstands von einem ausgewählten festen Substrat, während gleichzeitig eine nachteilige Einwirkung auf die Umwelt vermieden wird, und welches die folgenden Verfahrensschritte umfaßt:
(a) Bereitstellen einer Zusammensetzung, welche umfaßt:
(1) Wasserstoffperoxid in einer Menge von etwa 3 bis 5 Gew.-%, bezogen auf die Zusammensetzung;
(2) ein Metallhydroxid in einer ausreichenden Menge, um einen pH-Wert von mindestens 10,5 in der Zusammensetzung einzustellen;
(3) ein Netzmittel in einer Menge von etwa 0,1 bis 0,3 Gew.-%, bezogen auf die Zusammensetzung, wobei das Netzmittel aus Natrium-2-ethylhexylsulfat oder Natriummetasilikat ausgewählt ist; und
(4) reines Wasser als Rest der Zusammensetzung,
mit der Maßgabe, daß die Zusammensetzung kein Magnesiumsulfat und HEDP enthält; und
(b) Aussetzen des festen Substrats mit dem Flußmittelrückstand der Zusammensetzung, wobei der Flußmittelrückstand vom Substrat entfernt und in ungiftige und ungefährliche Produkte überführt wird.

6. Verfahren nach Anspruch 5, worin das Aussetzen mit der Zusammensetzung bei einer Temperatur im Bereich von 51,7 bis 71,1°C (125 bis 160°F) durchgeführt wird.

7. Verfahren nach Anspruch 5, welches weiterhin, nachdem das Substrat der Zusammensetzung ausgesetzt wurde, das Neutralisieren von Rückständen des Metallhydroxids oder Produkten davon auf dem Substrat, das Spülen des Substrats mit Wasser und das Trocknen des Substrats umfaßt.

8. Verfahren nach Anspruch 7, worin das Neutralisieren das Aussetzen des Substrats einem heißen kohlensäurehaltigen Wasser umfaßt.

9. Verfahren nach Anspruch 5, worin das Aussetzen in Schritt "b" weiterhin das Aussetzen der Zusammensetzung und der organischen Verunreinigungen auf dem Substrat einer Ultraviolettstrahlung mit einer Wellenlänge im Bereich von 184 bis 300 nm umfaßt.

## Revendications

1. Composition pour l'élimination d'un résidu de flux d'un substrat solide choisi par décomposition dudit résidu de flux en sous-produits non dangereux, ladite composition comprenant :
(a) du peroxyde d'hydrogène en une quantité d'environ 3 à 5 % en poids de ladite composition ;
(b) un hydroxyde métallique en une quantité suffisante pour porter le pH à au moins 10,5 dans ladite composition ;
(c) un agent mouillant en une quantité d'environ 0,1 à 0,3 % en poids de ladite composition, ledit agent mouillant étant choisi entre le 2-éthylhexylsulfate de sodium et le métasilicate de sodium ; et
(d) de l'eau purifiée, formant le reste de ladite composition,
sous réserve que ladite composition ne renferme pas du sulfate de magnésium et du HEDP.

2. Composition suivant la revendication 1, dans laquelle l'hydroxyde métallique est l'hydroxyde de sodium ou l'hydroxyde de potassium.

3. Composition suivant la revendication 1, comprenant en outre un agent de protection des métaux, en une quantité d'environ 0,5 à 2,0 % en poids de ladite composition.

4. Composition suivant la revendication 3, dans laquelle :
(a) le peroxyde d'hydrogène est présent en une quantité d'environ 3,0 % en poids de ladite composition ;
(b) l'hydroxyde métallique consiste en hydroxyde de sodium et est présent en une quantité d'environ 0,2 % en poids de ladite composition ;
(c) l'agent mouillant consiste en 2-éthylhexylsulfate de sodium et est présent en une quantité d'environ 0,1 % en poids de ladite composition ;
(d) l'agent protecteur des métaux consiste en métasilicate de sodium et est présent en une quantité d'environ 0,5 % en poids de ladite composition.

5. Procédé pour éliminer un résidu de flux d'un substrat solide choisi tout en évitant simultanément un effet néfaste sur l'environnement, ledit procédé comprenant :
(a) la préparation d'une composition comprenant :
(1) du peroxyde d'hydrogène en une quantité d'environ 3 à 5 % en poids de ladite composition ;
(2) un hydroxyde métallique en une quantité suffisante pour porter le pH à au moins 10,5 dans ladite composition ;
(3) un agent mouillant en une quantité d'environ 0,1 à 0,3 % en poids de ladite composition, ledit agent mouillant étant choisi entre le 2-éthylhexylsulfate de sodium et le métasilicate de sodium ; et
(4) de l'eau purifiée, formant le reste de ladite composition,
sous réserve que ladite composition ne renferme pas de sulfate de magnésium et de HEDP ; et
(b) la mise en contact dudit substrat solide portant ledit résidu de flux avec ladite composition, ledit résidu de flux étant ainsi éliminé dudit substrat et transformé en produits non toxiques et non dangereux.

6. Procédé suivant la revendication 5, dans lequel la mise en contact avec la composition est effectuée à une température comprise dans l'intervalle de 51,7 à 71,1°C (125 à 160°F).

7. Procédé suivant la revendication 5, comprenant en outre, après la mise en contact du substrat avec la composition, la neutralisation de l'hydroxyde métallique résiduel ou de ses produits formés sur ledit substrat, le rinçage dudit substrat avec de l'eau et le séchage dudit substrat.

8. Procédé suivant la revendication 7, dans lequel la neutralisation comprend la mise en contact dudit substrat avec de l'eau carbonatée chaude.

9. Procédé suivant la revendication 5, dans lequel la mise en contact, dans l'étape "b", comprend en outre la mise en contact de la composition et des impuretés organiques présentes sur le substrat à un rayonnement ultraviolet ayant-une longueur d'onde comprise dans l'intervalle de 184 à 300 nanomètres.
